# EUROPEAN PATENT SPECIFICATION

(11) **EP 3 539 676 B1**
(45) Date of publication and mention of the grant of the patent: **14.07.2021**
(21) Application number: 17876726.5
(22) Date of filing: 25.04.2017
(51) Int. Cl.: B05B 16/00, C23C 16/00, H01J 37/32

(54) **PLASMA POLYMERIZATION COATING DEVICE**
PLASMA-POLYMERISATIONSBESCHICHTUNGVORRICHTUNG
DISPOSITIF DE REVÊTEMENT DE POLYMÉRISATION PLASMA

(30) Priority: 30.11.2016 CN 201611076904
(43) Date of publication of application: 18.09.2019
(73) Proprietor: Jiangsu Favored Nanotechnology Co., Ltd., East Loop Yuqi Industrial Park Wuxi, Jiangsu 214183 (CN)
(72) Inventor: ZONG, Jian, Wuxi, Jiangsu 214183 (CN)
(74) Representative: Berkkam, Ayfer
(86) International application number: PCT/CN2017/081773
(87) International publication number: WO 2018/098980

(56) References cited:
- EP-A1- 0 490 883
- CN-A- 87 106 283
- CN-A- 105 949 836
- CN-A- 105 949 836
- CN-U- 206 304 929
- JP-A- S5 938 375
- JP-A- S6 043 488
- JP-A- H01 205 078
- JP-A- S59 211 220
- JP-A- 2007 297 661
- JP-A- 2007 297 661
- US-A1- 2018 330 922

## Description

### Technical Field

The present invention belongs to the technical field of plasma engineering, and particularly relates to a plasma coating device.

### Technical Background

Plasma polymerization coating processing is an important surface treatment method. In the plasma polymerization coating processing, the substrate to be treated is placed in a vacuum chamber. Carrier gas and organic gaseous monomer shall be introduced into the vacuum chamber in vacuum state; plasma processing is performed on an organic gaseous monomer through discharge to produce various kinds of reactive species; and an addition reaction is conducted between the reactive species or between the reactive species and the monomer to form a polymer film on the surface of the substrate. In some applications of hydrophobic films, nanoscale plasma polymerization coatings have excellent properties. However, because the film layer of the nanometer polymer coating is very thin, it has high requirements for the uniformity of the coating. The existing plasma nanometer coating device uses a square vacuum chamber. During coating processing, a fixture and the substrate placed on it are fixed in the vacuum chamber. Due to the differences of distances from different positions of different substrates processed in the same batch in the vacuum chamber to electrodes, monomer/carrier gas outlets and vacuum vents, the difference of coating uniformity is inevitable. In order to reduce the non-uniformity of the batch processing, the existing plasma nanometer coating device can only use a vacuum chamber with small volume and a small single processing batch, which greatly reduces the processing efficiency and increases the cost. Even so, satisfactory batch processing uniformity still cannot be achieved. With the rapid development of the application of the current nanometer polymer coating, processing needs and batches are increased rapidly. It is realistic and urgent to solve the problems of small batch, low efficiency, high cost and poor batch processing uniformity in the prior art of current plasma nanometer coating processing.

Relevant prior art documents include CN 105949836 A (WUXI RJ IND CO LTD) 21 Sept 2016, also published as US 2018/330922 A1 (ZONG JIAN [CN] (15 November 2018) Jian discloses a grid control, and plasma-initiated gas-phase polymerization apparatus the includes porous electrodes in a vacuum chamber, discharge cavities, an exhaust gas collection tube and a monomer vapor pipe that is connected to the side of the processing chamber that is near the discharging cavity.

EP 0490883 A1 (SEMICONDUCTOR ENERGY LAB [JP]) 17 June 1992. EP 0490883 discloses a chemical vapour deposition (CVD) apparatus that includes a chamber in which a substrate holder and a plurality of light sources are operable configured for photo CVD of the substrate.

JP 2007 297661 A (CANON KK) 15 November 2007. JP 2007 297661 publication discloses a plasma-initiated gas-phase polymerization apparatus that includes porous electrodes in a vacuum chamber configured for chemical vapour deposition onto a substrate positioned on a rack.

### Summary

A technical problem to be solved by the present invention is to provide a plasma polymerization coating device, so as to solve the problems of small volume, small batch in single processing, low processing efficiency, high cost and poor uniformity of batch processing in a square vacuum chamber adopted by the existing plasma nanometer coating device.

The technical solution of the present invention is: A plasma polymerization coating device comprising a vacuum chamber, wherein any cross section of a chamber body inner wall of the side part of the vacuum chamber is a circle with the same diameter or a regular polygon with the same edge length, wherein the regular polygon has at least 6 edges.

Porous electrodes are installed in the vacuum chamber proximal to the inner wall of the vacuum chamber; the porous electrodes form porous arched structures with a distance from the inner wall of the vacuum chamber; the porous electrodes are connected with a high frequency power source with a power of 15-1000 W; the porous electrodes are powered by the high frequency power source; plasma produced during discharge is used for surface cleaning and pretreatment of the substrate.

At least two discharge cavities are installed on an outer wall of the vacuum chamber in a sealed manner; the porous electrodes and each discharge cavity can discharge jointly or discharge independently according to the process need.

The porous electrodes produce plasma used for cleaning, i.e., surface cleaning: the porous electrodes continuously discharge with high power produce strong plasma and are used for cleaning organic impurities such as water vapor and oil stain on the substrate surface before coating or activating the organic substrate to form dangling bonds on the substrate surface to facilitate coating deposition and enhance the binding force between the substrate and the coating. The porous electrodes do not work during the coating process.

The discharge cavities produce plasma used for polymerization: during the coating process, each discharge cavity discharges with smaller power to produce weaker plasma; and the metal grids control to intermittently release the plasma to enter the vacuum chamber to initiate monomer polymerization and deposit on the substrate surface to form the coating.

At least two layers of metal grids are arranged at where the discharge cavities connect to the inner walls of the vacuum chamber. The metal grids are insulated from the inner walls of the vacuum chamber. The metal grids are connected to a pulse power source. The pulse power source has the action of exerting positive pulse bias to the metal grids to intermittently release the plasma in the discharge cavities into the vacuum chamber, wherein during pulse shutoff, the plasma is blocked by the multilayer metal grid into the discharge cavities, and during pulse exerting, the plasma penetrates through the multilayer metal grid to enter the vacuum chamber to initiate the monomer vapor in the vacuum chamber to generate the polymerization reaction.

A discharge source is disposed in the discharge cavity and is connected to a power source. The discharge cavity is connected with a carrier gas pipe. The other end of the carrier gas pipe is connected to a carrier gas source. A monomer vapor pipe is connected to the vacuum chamber, and an outlet thereof is located in front of the discharge cavity, with the other end of the monomer vapor pipe being connected to a monomer vapor source.

A tail gas collecting tube is vertically provided along the central axis of the vacuum chamber. One end of the tail gas collecting tube extends from the vacuum chamber and is connected to a vacuum pump, and holes are provided on the wall of the tail gas collecting tube.

A rotation rack is disposed in the vacuum chamber. The rotation shaft of the rotation rack is coaxial with the central axis of the vacuum chamber. The substrate to be treated is placed on the rotation rack.

A top cover and a bottom cover of the vacuum chamber are in a flat or an arched structure (such as spherical interior structure, regular polygon and oval) matching the cross section of the chamber body inner wall of the side part of the vacuum chamber.

The porous electrodes are in a cylindrical shape or at least divided into two sections of cylindrical shape and are coaxial with the vacuum chamber; the distance from the inner wall of the vacuum chamber ranges from 1 to 6 cm; the porous electrodes are covered by through holes; the size of a through hole ranges from 2 to 30 mm; and the space between the through holes ranges from 2 to 30 mm.

The discharge cavity is in a cylindrical shape and is made from a material of aluminum, carbon steel or stainless steel; the diameter of the discharge cavity ranges from 5 to 20 cm; the depth of the discharge cavity is from 3 to 15 cm; and the distance between axes of two neighboring discharge cavities ranges from 7 to 40 cm.

The number of layers of the metal grid ranges from 2 to 6; the metal grid is made of stainless steel or nickel; the size of openings of the metal grid ranges from 100 to 1000 mesh; and the transmissivity of the metal grid ranges from 25% to 40%.

The pulse power source outputs a positive pulse with the following parameters: pulse peak ranging from 20 to 140V, pulse width ranging from 2 µs to 1 ms and repeat frequency ranging from 20 Hz to 10 kHz.

The discharge source is a lamp filament, an electrode, an induction coil, or a microwave antenna, and has the discharge power ranging from 2 to 500 W.

The distance between the outlet end of the monomer vapor pipe and the discharge cavity ranges from 1 to 10 cm.

An inner diameter of the tail gas collecting tube ranges from 25 to 100 mm; the holes of the tail gas collecting tube are evenly provided on the wall of the tail gas collecting tube; the hole size ranges from 2 to 30 mm; and the space between the holes of the tail gas collecting tube ranges from 2 to 100 mm.

The rotation shaft of the rotation rack is coaxial with the central axis of the vacuum chamber; the rotation rack is adapted to rotate about the rotation shaft thereof; 2 to 8 layers of substrate platforms are symmetrically fixed to the rotation rack; and the substrate platforms are configured for placing the substrate to be treated.

The rotation shaft of the rotation rack is coaxial with the central axis of the vacuum chamber; the rotation rack is adapted to rotate about the rotation shaft thereof; 2 to 8 planetary rotation shafts are symmetrically provided on the rotation rack; and the planetary rotation shafts are perpendicular to the rotation rack and are able to rotate.

The planetary rotation shafts are provided with 2 to 8 layers of rotation substrate platforms, and the substrate platforms are configured for placing the substrate to be treated.

The present invention has the following beneficial effects:
1. The structure of the central and axis symmetric vacuum chamber is adopted to keep the stability of the concentration of the spatial polymerization reaction active species.
   Gas intake on the side wall of the vacuum chamber, radial transport and exhaust in the central axis are adopted.
   The outlet of the carrier gas pipe is provided in each discharge cavity; the carrier gas is delivered into each discharge cavity through the pipe thereof, and then diffuses into the vacuum chamber through the multilayer metal grid. The outlet of the monomer steam pipe is provided in front of the outer part of each discharge cavity in the vacuum chamber; and the monomer vapor is delivered into the vacuum chamber through the pipe thereof. The tail gas collecting tube is provided coaxially with the vacuum chamber along the axis of the vacuum chamber; the tail gas collecting tube longitudinally penetrates through the vacuum chamber; the pipe end is in communication with the vacuum pump; holes are provided uniformly on the wall of the tail gas collecting tube; and tail gas enters the tail gas collecting tube through the holes on the tail gas collecting tube and is discharged from the vacuum chamber through the vacuum pump.
   In the manner of gas intake on the side wall of the vacuum chamber, radial transport and exhaust in the central axis, the gas transport process is gathered, which is beneficial for enhancing the stability of the concentration of the active species of the spatial polymerization reaction. The distribution of the active species is more uniform. In the process: the monomer vapor generates the polymerization reaction active species by the plasma effect near each discharge cavity. The polymerization reaction active species are transported along the radial direction towards the axial direction of the vacuum chamber under the drive of the carrier gas. In the transport process, the number of the consumed polymerization reaction active species is continuously reduced, but on the other hand, the polymerization reaction active species are constantly collected in the transport process, so as to compensate the number reduction and keep the concentration stable. The volume density of the active species in the vacuum chamber keeps unchanged. Batch processing is good in uniformity. The thickness difference of the substrate coating of the same batch processing in the existing coating device and technology is more than 30%, while the thickness difference of the substrate coating of the same batch processing in the present invention is less than 10%.
2. The rotation rack is adopted to obviously enhance the uniformity of the substrate coatings.
   The rotation rack is installed in the vacuum chamber. The rotation substrate platforms on the rotation rack rotate or make planetary rotation motion in the vacuum chamber. Especially, the planetary rotation motion means that the rotation substrate platforms rotate around the planetary rotation shafts thereof, and also revolve around the coaxial line of the vacuum chamber along with the rotation shaft of the rotation rack. The substrate to be treated can be placed on the rotation substrate platforms. The planetary rotation ensures that the spatial position of the substrate in the coating processing continuously changes. The changes of the spatial positions of different substrates in one complete processing are identical, thereby eliminating the difference in coating effects caused by different spatial positions of different substrates in the prior art. Various substrates have the same processing extent and basically the same coating effects. The uniformity in various substrates is better.
3. The volume of the vacuum chamber can be greatly increased, and the processing efficiency is obviously increased.
   Because the improvement on the structure of the vacuum chamber and the rotation rack greatly enhances the film thickness uniformity of the batch processing coatings, the volume of the vacuum chamber can be increased to 5-6 times of the volume of the current vacuum chamber, the number and the processing efficiency of batch processing are substantially enhanced.
4. The multilayer grid has a retardation effect on the plasma and the monomer.

The multilayer metal grid has the retardation effect on the diffusion of the carrier gas from the discharge cavity to the vacuum chamber so that the atmospheric pressure in the discharge cavity is higher than the atmospheric pressure in the vacuum chamber. The multilayer metal grid has the retardation effect on back diffusion of the monomer vapor from the vacuum chamber to the discharge cavity. Because the atmospheric pressure in the discharge cavity is higher than the atmospheric pressure in the vacuum chamber, the monomer vapor is difficult to conduct back diffusion from the vacuum chamber to the discharge cavity, thereby preventing the monomer vapor from being excessively decomposed and destructed by continuous discharge of the discharge cavity. The apparatus of the present invention can effectively protect the monomer vapor from being decomposed and destructed, so as to obtain a polymer coating of very good quality.

### Description of Drawings

Fig. 1 is a front sectional structural schematic diagram of a plasma polymerization coating device in which planetary rotation shafts are disposed on a rotation rack in embodiment 1.
Fig. 2 is a schematic diagram of a top structure of Fig. 1.

In the figures: 1 vacuum chamber; 2 porous electrode; 3 high frequency power source; 4 discharge cavity; 5 multilayer metal grid; 6 pulse power source; 7 discharge source; 8 power source; 9 carrier gas pipe; 10 monomer vapor pipe; 11 tail gas collecting tube; 12 rotation rack; 13 planetary rotation shaft; 14 rotation substrate platforms; and 15 substrate.

### Detailed Description

Specific embodiments of the present invention are described below in detail in combination with the technical solution and drawings.

### Embodiment 1

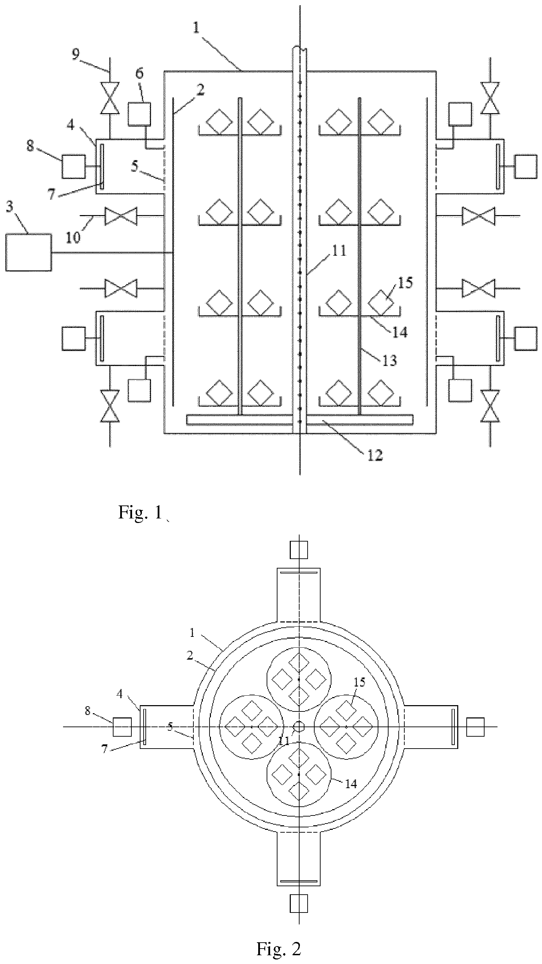

A plasma polymerization coating device as shown in Fig. 1 and Fig. 2 comprises a vacuum chamber. Any cross section of a chamber body inner wall of the side part of the vacuum chamber 1 is a circle with the same diameter, i.e., the chamber body inner wall of the vacuum chamber is a cylinder.

A top cover and a bottom cover of the vacuum chamber 1 are in a spherical interior structure matching the cross section of the chamber body inner wall of the side part of the vacuum chamber.

Porous electrodes 2 are installed in the vacuum chamber 1 proximal to the inner wall of the vacuum chamber 1; the porous electrodes 2 form porous arched structures with a distance from the inner wall of the vacuum chamber; the porous electrodes are connected with a high frequency power source 3; and eight discharge cavities 4 are installed on an outer wall of the vacuum chamber in a sealed manner.

The porous electrodes 2 are in a cylindrical shape and are coaxial with the vacuum chamber; the distance from the inner wall of the vacuum chamber is 1 cm; the porous electrodes 2 are covered by through holes; the size of a through hole is 30 mm; and the space between the through holes is 30 mm. The power of the high frequency power source connected to the porous electrodes is 15 W.

The discharge cavity 4 is in a cylindrical shape and is made from a material of aluminum; the diameter of the discharge cavity 4 is 5 cm; the depth of the discharge cavity 4 is 15 cm; and the distance between axes of two neighboring discharge cavities 4 is 40 cm. The distance between the outlet end of the monomer vapor pipe 10 and the discharge cavity 4 is 1 cm.

Two layers of metal grids 5 are arranged at where the discharge cavities connect to the inner walls of the vacuum chamber; the metal grids are insulated from the inner walls of the vacuum chamber; the metal grids are connected to a pulse power source 6; a discharge source 7 is disposed in the discharge cavity 4 and is connected to a power source 8; the discharge cavity is connected with a carrier gas pipe 9; the other end of the carrier gas pipe is connected to a carrier gas source; a monomer vapor pipe 10 is connected to the vacuum chamber, and an outlet end of the monomer vapor pipe 10 is located in front of the discharge cavity 4, with the other end of the monomer vapor pipe being connected to a monomer vapor source.

The metal grid is made of stainless steel; the size of openings of the metal grid is 100 mesh; and the transmissivity of the metal grid is 40%.

The pulse power source 6 outputs a positive pulse with the following parameters: pulse peak of 20 V, pulse width of 1 ms and repeat frequency of 10 kHz.

The discharge source 7 is a lamp filament, and has the discharge power of 2 W.

A tail gas collecting tube 11 is vertically provided along the central axis of the vacuum chamber; one end of the tail gas collecting tube extends from the vacuum chamber and is connected to a vacuum pump, and holes are provided on the wall of the tail gas collecting tube. An inner diameter of the tail gas collecting tube 11 is 25 mm; the holes of the tail gas collecting tube are evenly provided on the wall of the tail gas collecting tube; the hole size is 2 mm; and the space between the holes of the tail gas collecting tube is 2 mm.

The rotation rack 12 is arranged in the vacuum chamber. The rotation shaft of the rotation rack 12 is coaxial with the central axis of the vacuum chamber. The rotation rack is adapted to rotate about the rotation shaft thereof. Four planetary rotation shafts 13 are symmetrically provided on the rotation rack. The planetary rotation shafts are perpendicular to the rotation rack 12 and are able to rotate.

The planetary rotation shafts are provided with 4 layers of rotation substrate platforms 14. The substrate platforms are configured for placing the substrate 15 to be treated.

### Embodiment 2

A plasma polymerization coating device comprises a vacuum chamber 1. Any cross section of a chamber body inner wall of the side part of the vacuum chamber is a regular hexagon with the same edge length.

A top cover and a bottom cover of the vacuum chamber 1 are in an orthohexagonal arched structure matching the cross section of the chamber body inner wall of the side part of the vacuum chamber.

Porous electrodes 2 are installed in the vacuum chamber 1 proximal to the inner wall of the vacuum chamber 1; the porous electrodes 2 form porous arched structures with a distance from the inner wall of the vacuum chamber; the porous electrodes are connected with a high frequency power source 3; and two discharge cavities 4 are installed on an outer wall of the vacuum chamber in a sealed manner.

The porous electrodes 2 are divided into two sections of cylindrical shapes and are coaxial with the vacuum chamber; the distance from the inner wall of the vacuum chamber is 3 cm; the porous electrodes 2 are covered by through holes; the size of a through hole is 18 mm; and the space between the through holes is 15 mm. The power of the high frequency power source connected to the porous electrodes is 500 W.

The discharge cavity 4 is in a cylindrical shape and is made from a material of carbon steel; the diameter of the discharge cavity 4 is 20 cm; the depth of the discharge cavity 4 is 8 cm; and the distance between axes of two neighboring discharge cavities 4 is 20 cm. The distance between the outlet end of the monomer vapor pipe 10 and the discharge cavity 4 is 6 cm.

Four layers of metal grids 5 are arranged at where the discharge cavities connect to the inner walls of the vacuum chamber; the metal grids are insulated from the inner walls of the vacuum chamber; the metal grids are connected to a pulse power source 6; a discharge source 7 is disposed in the discharge cavity 4 and is connected to a power source 8; the discharge cavity is connected with a carrier gas pipe 9; the other end of the carrier gas pipe is connected to a carrier gas source; a monomer vapor pipe 10 is connected to the vacuum chamber, and an outlet end of the monomer vapor pipe 10 is located in front of the discharge cavity 4, with the other end of the monomer vapor pipe being connected to a monomer vapor source.

The metal grid is made of nickel; the size of openings of the metal grid is 600 mesh; and the transmissivity of the metal grid is 32%.

The pulse power source 6 outputs a positive pulse with the following parameters: pulse peak of 86 V, pulse width of 0.1 ms and repeat frequency of 700 Hz.

The discharge source 7 is an electrode, and has the discharge power of 280 W.

A tail gas collecting tube 11 is vertically provided along the central axis of the vacuum chamber; one end of the tail gas collecting tube extends from the vacuum chamber and is connected to a vacuum pump, and holes are provided on the wall of the tail gas collecting tube. An inner diameter of the tail gas collecting tube 11 is 60 mm; the holes of the tail gas collecting tube are evenly provided on the wall of the tail gas collecting tube; the hole size is 16 mm; and the space between the holes of the tail gas collecting tube is 55 mm.

The rotation rack 12 is arranged in the vacuum chamber. The rotation shaft of the rotation rack 12 is coaxial with the central axis of the vacuum chamber. The rotation rack is adapted to rotate about the rotation shaft thereof. Two planetary rotation shafts 13 are symmetrically provided on the rotation rack. The planetary rotation shafts are perpendicular to the rotation rack 12 and are able to rotate.

The planetary rotation shafts are provided with 8 layers of rotation substrate platforms 14. The substrate platforms are configured for placing the substrate 15 to be treated.

### Embodiment 3

A plasma polymerization coating device comprises a vacuum chamber 1. Any cross section of a chamber body inner wall of the side part of the vacuum chamber is a regular enneagon with the same edge length.

A top cover and a bottom cover of the vacuum chamber 1 are in an enneagon flat structure matching the cross section of the chamber body inner wall of the side part of the vacuum chamber.

Porous electrodes 2 are installed in the vacuum chamber 1 proximal to the inner wall of the vacuum chamber 1; the porous electrodes 2 form porous arched structures with a distance from the inner wall of the vacuum chamber; the porous electrodes are connected with a high frequency power source 3; and two discharge cavities 4 are installed on an outer wall of the vacuum chamber in a sealed manner.

The porous electrodes 2 are divided into four sections of cylindrical shapes and are coaxial with the vacuum chamber; the distance from the inner wall of the vacuum chamber is 6 cm; the porous electrodes 2 are covered by through holes; the size of a through hole is 30 mm; and the space between the through holes is 30 mm. The power of the high frequency power source connected to the porous electrodes is 1000 W.

The discharge cavity 4 is in a cylindrical shape and is made from a material of stainless steel; the diameter of the discharge cavity 4 is 12 cm; the depth of the discharge cavity 4 is 3 cm; and the distance between axes of two neighboring discharge cavities 4 is 7 cm. The distance between the outlet end of the monomer vapor pipe 10 and the discharge cavity 4 is 10 cm.

Five layers of metal grids 5 are arranged at where the discharge cavities connect to the inner walls of the vacuum chamber; the metal grids are insulated from the inner walls of the vacuum chamber; the metal grids are connected to a pulse power source 6; a discharge source 7 is disposed in the discharge cavity 4 and is connected to a power source 8; the discharge cavity is connected with a carrier gas pipe 9; the other end of the carrier gas pipe is connected to a carrier gas source; a monomer vapor pipe 10 is connected to the vacuum chamber, and an outlet end of the monomer vapor pipe 10 is located in front of the discharge cavity 4, with the other end of the monomer vapor pipe being connected to a monomer vapor source.

The metal grid is made of nickel; the size of openings of the metal grid is 1000 mesh; and the transmissivity of the metal grid is 25%.

The pulse power source 6 outputs a positive pulse with the following parameters: pulse peak of 140 V, pulse width of 2 µs and repeat frequency of 20 Hz.

The discharge source 7 is a microwave antenna, and has the discharge power of 500 W.

A tail gas collecting tube 11 is vertically provided along the central axis of the vacuum chamber; one end of the tail gas collecting tube extends from the vacuum chamber and is connected to a vacuum pump, and holes are provided on the wall of the tail gas collecting tube. An inner diameter of the tail gas collecting tube 11 is 100 mm; the holes of the tail gas collecting tube are evenly provided on the wall of the tail gas collecting tube; the hole size is 30 mm; and the space between the holes of the tail gas collecting tube is 100 mm.

The rotation rack 12 is arranged in the vacuum chamber. The rotation shaft of the rotation rack 12 is coaxial with the central axis of the vacuum chamber. The rotation rack is adapted to rotate about the rotation shaft thereof. Eight planetary rotation shafts 13 are symmetrically provided on the rotation rack. The planetary rotation shafts are perpendicular to the rotation rack 12 and are able to rotate.

The planetary rotation shafts are provided with 2 layers of rotation substrate platforms 14. The substrate platforms are configured for placing the substrate 15 to be treated.

### Embodiment 4

A plasma polymerization coating device comprises a vacuum chamber 1. Any cross section of a chamber body inner wall of the side part of the vacuum chamber is a regular dodecagon with the same edge length.

A top cover and a bottom cover of the vacuum chamber 1 are in a dodecagonal arched structure matching the cross section of the chamber body inner wall of the side part of the vacuum chamber.

Porous electrodes 2 are installed in the vacuum chamber 1 proximal to the inner wall of the vacuum chamber 1; the porous electrodes 2 form porous arched structures with a distance from the inner wall of the vacuum chamber; the porous electrodes are connected with a high frequency power source 3; and two discharge cavities 4 are installed on an outer wall of the vacuum chamber in a sealed manner.

The porous electrodes 2 are divided into five sections of cylindrical shapes and are coaxial with the vacuum chamber; the distance from the inner wall of the vacuum chamber is 5 cm; the porous electrodes 2 are covered by through holes; the size of a through hole is 12 mm; and the space between the through holes is 18 mm. The power of the high frequency power source connected to the porous electrodes is 260 w.

The discharge cavity 4 is in a cylindrical shape and is made from a material of stainless steel; the diameter of the discharge cavity 4 is 16 cm; the depth of the discharge cavity 4 is 6 cm; and the distance between axes of two neighboring discharge cavities 4 is 26 cm. The distance between the outlet end of the monomer vapor pipe 10 and the discharge cavity 4 is 4 cm.

Six layers of metal grids 5 are arranged at where the discharge cavities connect to the inner walls of the vacuum chamber; the metal grids are insulated from the inner walls of the vacuum chamber; the metal grids are connected to a pulse power source 6; a discharge source 7 is disposed in the discharge cavity 4 and is connected to a power source 8; the discharge cavity is connected with a carrier gas pipe 9; the other end of the carrier gas pipe is connected to a carrier gas source; a monomer vapor pipe 10 is connected to the vacuum chamber, and an outlet end of the monomer vapor pipe 10 is located in front of the discharge cavity 4, with the other end of the monomer vapor pipe being connected to a monomer vapor source.

The metal grid is made of nickel; the size of openings of the metal grid is 360 mesh; and the transmissivity of the metal grid is 28%.

The pulse power source 6 outputs a positive pulse with the following parameters: pulse peak of 115 V, pulse width of 160 µs and repeat frequency of 380 Hz.

The discharge source 7 is a lamp filament, and has the discharge power of 130 W.

A tail gas collecting tube 11 is vertically provided along the central axis of the vacuum chamber; one end of the tail gas collecting tube extends from the vacuum chamber and is connected to a vacuum pump, and holes are provided on the wall of the tail gas collecting tube. An inner diameter of the tail gas collecting tube 11 is 85 mm; the holes of the tail gas collecting tube are evenly provided on the wall of the tail gas collecting tube; the hole size is 18 mm; and the space between the holes of the tail gas collecting tube is 38 mm.

The rotation shaft of the rotation rack is coaxial with the central axis of the vacuum chamber; the rotation rack is adapted to rotate about the rotation shaft thereof; 2 layers of substrate platforms are symmetrically fixed to the rotation rack; and the substrate platforms are configured for placing the substrate to be treated.

### Embodiment 5

A plasma polymerization coating device comprises a vacuum chamber. Any cross section of a chamber body inner wall of the side part of the vacuum chamber is a circle with the same diameter, i.e., the chamber body inner wall of the vacuum chamber is a cylinder.

A top cover and a bottom cover of the vacuum chamber 1 are in a circular flat structure matching the cross section of the chamber body inner wall of the side part of the vacuum chamber.

Porous electrodes 2 are installed in the vacuum chamber 1 proximal to the inner wall of the vacuum chamber 1; the porous electrodes 2 form porous arched structures with a distance from the inner wall of the vacuum chamber; the porous electrodes are connected with a high frequency power source 3; and two discharge cavities 4 are installed on an outer wall of the vacuum chamber in a sealed manner.

The porous electrodes 2 are divided into eight sections of cylindrical shapes and are coaxial with the vacuum chamber; the distance from the inner wall of the vacuum chamber is 2 cm; the porous electrodes 2 are covered by through holes; the size of a through hole is 5 mm; and the space between the through holes is 12 mm. The power of the high frequency power source connected to the porous electrodes is 120 W.

The discharge cavity 4 is in a cylindrical shape and is made from a material of carbon steel; the diameter of the discharge cavity 4 is 11 cm; the depth of the discharge cavity 4 is 8 cm; and the distance between axes of two neighboring discharge cavities 4 is 20 cm. The distance between the outlet end of the monomer vapor pipe 10 and the discharge cavity 4 is 7 cm.

Three layers of metal grids 5 are arranged at where the discharge cavities connect to the inner walls of the vacuum chamber; the metal grids are insulated from the inner walls of the vacuum chamber; the metal grids are connected to a pulse power source 6; a discharge source 7 is disposed in the discharge cavity 4 and is connected to a power source 8; the discharge cavity is connected with a carrier gas pipe 9; the other end of the carrier gas pipe is connected to a carrier gas source; a monomer vapor pipe 10 is connected to the vacuum chamber, and an outlet end of the monomer vapor pipe 10 is located in front of the discharge cavity 4, with the other end of the monomer vapor pipe being connected to a monomer vapor source.

The metal grid is made of nickel; the size of openings of the metal grid is 640 mesh; and the transmissivity of the metal grid is 30%.

The pulse power source 6 outputs a positive pulse with the following parameters: pulse peak of 58 V, pulse width of 620 µs and repeat frequency of 55 Hz.

The discharge source 7 is an induction coil, and has the discharge power of 480 W.

A tail gas collecting tube 11 is vertically provided along the central axis of the vacuum chamber; one end of the tail gas collecting tube extends from the vacuum chamber and is connected to a vacuum pump, and holes are provided on the wall of the tail gas collecting tube. An inner diameter of the tail gas collecting tube 11 is 45 mm; the holes of the tail gas collecting tube are evenly provided on the wall of the tail gas collecting tube; the hole size is 24 mm; and the space between the holes of the tail gas collecting tube is 58 mm.

The rotation shaft of the rotation rack is coaxial with the central axis of the vacuum chamber; the rotation rack is adapted to rotate about the rotation shaft thereof; 8 layers of substrate platforms are symmetrically fixed to the rotation rack; and the substrate platforms are configured for placing the substrate to be treated.

## Claims

1. A plasma polymerization coating device, comprising a vacuum chamber, wherein any cross section of a chamber body inner wall of the side part of the vacuum chamber (1) is a circle with the same diameter or a polygon with the same edge length, wherein the polygon has at least 6 edges;
porous electrodes (2) are installed in the vacuum chamber (1) proximal to the inner wall of the vacuum chamber (1); the porous electrodes (2) form porous arched structures with a distance from the inner wall of the vacuum chamber; the porous electrodes are connected with a high frequency power source (3); at least two discharge cavities (4) are installed on an outer wall of the vacuum chamber in a sealed manner;
at least two layers of metal grids (5) are arranged at where the discharge cavities connect to the inner walls of the vacuum chamber; the metal grids are insulated from the inner walls of the vacuum chamber; the metal grids are connected to a pulse power source (6); a discharge source (7) is disposed in the discharge cavity (4) and is connected to a power source (8); the discharge cavity is connected with a carrier gas pipe (9); the other end of the carrier gas pipe is connected to a carrier gas source; a monomer vapor pipe (10) is connected to the vacuum chamber, and an outlet end of the monomer vapor pipe (10) is located in front of the discharge cavity (4), with the other end of the monomer vapor pipe being connected to a monomer vapor source;
a tail gas collecting tube (11) is vertically provided along the central axis of the vacuum chamber; one end of the tail gas collecting tube extends from the vacuum chamber and is connected to a vacuum pump, and holes are provided on the wall of the tail gas collecting tube;
a rotation rack (12) is disposed in the vacuum chamber; the rotation shaft of the rotation rack is coaxial with the central axis of the vacuum chamber; and the substrate to be treated is placed on the rotation rack.

2. The plasma polymerization coating device according to claim 1, wherein a top cover and a bottom cover of the vacuum chamber (1) are in a flat or an arched structure matching the cross section of the chamber body inner wall of the side part of the vacuum chamber.

3. The plasma polymerization coating device according to claim 1, wherein the porous electrodes (2) are in a cylindrical shape or at least divided into two sections of cylindrical shape and are coaxial with the vacuum chamber, that the distance from the inner wall of the vacuum chamber ranges from 1 to 6 cm, that the porous electrodes (2) are covered by through holes, that the size of a through hole ranges from 2 to 30 mm, that the space between the through holes ranges from 2 to 30 mm, and that the power of the high frequency power source (3) connected to the porous electrodes ranges from 15 to 1000 W.

4. The plasma polymerization coating device according to claim 1, wherein the discharge cavity (4) is in a cylindrical shape and is made from a material of aluminum, carbon steel or stainless steel, that the diameter of the discharge cavity (4) ranges from 5 to 20 cm, that the depth of the discharge cavity (4) is from 3 to 15 cm, that the distance between axes of two neighboring discharge cavities (4) ranges from 7 to 40 cm, and that the distance between the outlet end of the monomer vapor pipe (10) and the discharge cavity (4) ranges from 1 to 10 cm.

5. The plasma polymerization coating device according to claim 1, wherein the number of layers of the metal grid (5) ranges from 2 to 6, that the metal grid (5) is made of stainless steel or nickel, that the size of openings of the metal grid (5) ranges from 100 to 1000 mesh, and the transmissivity of the metal grid (5) ranges from 25% to 40%.

6. The plasma polymerization coating device according to claim 1, wherein the pulse power source (6) outputs a positive pulse with the following parameters: pulse peak ranging from 20 to 140V, pulse width ranging from 2 µs to 1 ms and repeat frequency ranging from 20 Hz to 10 kHz.

7. The plasma polymerization coating device according to claim 1, wherein the discharge source (7) is a lamp filament, an electrode, an induction coil, or a microwave antenna, and has the discharge power ranging from 2 to 500 W.

8. The plasma polymerization coating device according to claim 1, wherein an inner diameter of the tail gas collecting tube (11) ranges from 25 to 100 mm, that the holes of the tail gas collecting tube are evenly provided on the wall of the tail gas collecting tube, that the hole size ranges from 2 to 30 mm, and that the space between the holes of the tail gas collecting tube ranges from 2 to 100 mm.

9. The plasma polymerization coating device according to claim 1, wherein the rotation shaft of the rotation rack is coaxial with the central axis of the vacuum chamber, that the rotation rack is adapted to rotate about the rotation shaft thereof, that 2 to 8 layers of substrate platforms are symmetrically fixed to the rotation rack, and that the substrate platforms are configured for placing the substrate to be treated.

10. The plasma polymerization coating device according to claim 1, wherein the rotation rack is adapted to rotate about the rotation shaft thereof, that 2 to 8 planetary rotation shafts (13) are symmetrically provided on the rotation rack, that the planetary rotation shafts are perpendicular to the rotation rack (12) and are able to rotate, wherein the planetary rotation shafts are provided with 2 to 8 layers of rotation substrate platforms (14), and wherein the substrate platforms are configured for placing the substrate to be treated (15).

## Patentansprüche

1. Plasmapolymerisationsbeschichtungsvorrichtung, umfassend eine Vakuumkammer, wobei
jeder Querschnitt einer Kammerkörperinnenwand des Seitenteils der Vakuumkammer (1) ein Kreis mit demselben Durchmesser oder ein Polygon mit derselben Kantenlänge ist, wobei das Polygon mindestens 6 Kanten aufweist;
poröse Elektroden (2) in der Vakuumkammer (1) proximal zur Innenwand der Vakuumkammer (1) installiert sind; die porösen Elektroden (2) poröse, gewölbte Strukturen mit einem Abstand von der Innenwand der Vakuumkammer bilden; die porösen Elektroden mit einer Hochfrequenz-Leistungsquelle (3) verbunden sind; mindestens zwei Entladungshohlräume (4) an einer Außenwand der Vakuumkammer in einer abgedichteten Weise installiert sind;
mindestens zwei Schichten von Metallgittern (5) dort angeordnet sind, wo die Entladungshohlräume mit den Innenwänden der Vakuumkammer verbunden sind; die Metallgitter von den Innenwänden der Vakuumkammer isoliert sind; die Metallgitter mit einer Pulsleistungsquelle (6) verbunden sind; eine Entladungsquelle (7) in dem Entladungshohlraum (4) angeordnet ist und mit einer Leistungsquelle (8) verbunden ist; der Entladungshohlraum mit einer Trägergasleitung (9) verbunden ist; das andere Ende der Trägergasleitung mit einer Trägergasquelle verbunden ist; eine Monomerdampfleitung (10) mit der Vakuumkammer verbunden ist, und ein Auslassende der Monomerdampfleitung (10) vor dem Entladungshohlraum (4) angeordnet ist, durch das andere Ende des Monomerdampfrohrs mit einer Monomerdampfquelle verbunden ist;
ein Endgassammelrohr (11) vertikal entlang der Mittelachse der Vakuumkammer vorgesehen ist; ein Ende des Endgassammelrohrs sich aus der Vakuumkammer erstreckt und mit einer Vakuumpumpe verbunden ist, und Löcher an der Wand des Endgassammelrohrs vorgesehen sind;
ein Rotationsgestell (12) in der Vakuumkammer angeordnet ist; die Rotationswelle des Rotationsgestells koaxial mit der Mittelachse der Vakuumkammer ist; und das zu behandelnde Substrat auf dem Rotationsgestell angeordnet ist.

2. Plasmapolymerisationsbeschichtungsvorrichtung nach Anspruch 1, wobei eine obere Abdeckung und eine untere Abdeckung der Vakuumkammer (1) in einer flachen oder einer gewölbten Struktur vorliegen, die dem Querschnitt der Kammerkörperinnenwand des Seitenteils der Vakuumkammer entspricht.

3. Plasmapolymerisationsbeschichtungsvorrichtung nach Anspruch 1, wobei die porösen Elektroden (2) eine zylindrische Form aufweisen oder zumindest in zwei Abschnitte zylindrischer Form unterteilt sind und koaxial zur Vakuumkammer angeordnet sind, der Abstand von der Innenwand der Vakuumkammer im Bereich von 1 bis 6 cm liegt, die porösen Elektroden (2) von Durchgangslöchern bedeckt sind, die Größe eines Durchgangslochs im Bereich von 2 bis 30 mm liegt, der Abstand zwischen den Durchgangslöchern im Bereich von 2 bis 30 mm liegt, und die Leistung der Hochfrequenz-Leistungsquelle (3), die mit den porösen Elektroden verbunden ist, im Bereich von 15 bis 1000 W liegt.

4. Die Plasmapolymerisationsbeschichtungsvorrichtung nach Anspruch 1, wobei der Entladungshohlraum (4) eine zylindrische Form hat und aus einem Material aus Aluminium, Kohlenstoffstahl oder rostfreiem Stahl hergestellt ist, der Durchmesser des Entladungshohlraums (4) im Bereich von 5 bis 20 cm liegt, die Tiefe des Entladungshohlraums (4) im Bereich von 3 bis 15 cm liegt, der Abstand zwischen den Achsen zweier benachbarter Entladungshohlräume (4) im Bereich von 7 bis 40 cm liegt, und der Abstand zwischen dem Auslassende der Monomerdampfleitung (10) und dem Entladungshohlraum (4) im Bereich von 1 bis 10 cm liegt.

5. Plasmapolymerisationsbeschichtungsvorrichtung nach Anspruch 1, wobei die Anzahl der Schichten des Metallgitters (5) im Bereich von 2 bis 6 liegt, das Metallgitter (5) aus rostfreiem Stahl oder Nickel hergestellt ist, die Größe der Öffnungen des Metallgitters (5) im Bereich von 100 bis 1000 Machen liegt und die Durchlässigkeit des Metallgitters (5) im Bereich von 25% bis 40% liegt.

6. Plasmapolymerisationsbeschichtungsvorrichtung nach Anspruch 1, wobei
die Pulsleistungsquelle (6) einen positiven Puls mit den folgenden Parametern ausgibt: Pulsspitze im Bereich von 20 bis 140 V, Pulsbreite im Bereich von 2 µs bis 1 ms und Wiederholfrequenz im Bereich von 20 Hz bis 10 kHz.

7. Plasmapolymerisationsbeschichtungsvorrichtung nach Anspruch 1, wobei
die Entladungsquelle (7) ein Lampenwendel, eine Elektrode, eine Induktionsspule oder eine Mikrowellenantenne ist und eine Entladungsleistung im Bereich von 2 bis 500 W aufweist.

8. Die Plasmapolymerisationsbeschichtungsvorrichtung nach Anspruch 1, wobei
ein Innendurchmesser des Endgassammelrohrs (11) im Bereich von 25 bis 100 mm liegt, die Löcher des Endgassammelrohrs gleichmäßig an der Wand des Endgassammelrohrs vorgesehen sind, die Lochgröße im Bereich von 2 bis 30 mm liegt, und der Abstand zwischen den Löchern des Endgassammelrohrs im Bereich von 2 bis 100 mm liegt.

9. Plasmapolymerisationsbeschichtungsvorrichtung nach Anspruch 1, wobei
die Rotationswelle des Rotationsgestells koaxial mit der zentralen Achse der Vakuumkammer ist, das Rotationsgestell so angepasst ist, dass es sich um seine Rotationswelle dreht, 2 bis 8 Schichten von Substratplattformen symmetrisch an dem Rotationsgestell befestigt sind, und die Substratplattformen zum Platzieren des zu behandelnden Substrats konfiguriert sind.

10. Plasmapolymerisationsbeschichtungsvorrichtung nach Anspruch 1, wobei
das Rotationsgestell um seine Rotationswelle drehbar ist, 2 bis 8 Planetenrotationswellen (13) symmetrisch an dem Rotationsgestell vorgesehen sind, die Planetenrotationswellen senkrecht zu dem Rotationsgestell (12) stehen und drehbar sind, wobei die Planetenrotationswellen mit 2 bis 8 Lagen von Rotationssubstratplattformen (14) vorgesehen sind, und wobei die Substratplattformen zum Auflegen des zu behandelnden Substrats (15) konfiguriert sind.

## Revendications

1. Dispositif de revêtement par polymérisation au plasma, comprenant une chambre à vide,
dans lequel toute section transversale d'une paroi intérieure de corps de chambre de la partie latérale de la chambre à vide (1) est un cercle avec le même diamètre ou un polygone avec la même longueur de bord, dans lequel le polygone a au moins 6 bords ;
les électrodes poreuses (2) sont installées dans la chambre à vide (1) à proximité de la paroi interne de la chambre à vide (1) ; les électrodes poreuses (2) forment des structures poreuses arquées à une certaine distance de la paroi interne de la chambre à vide ; les électrodes poreuses sont connectées à une source d'énergie haute fréquence (3) ; au moins deux cavités de décharge (4) sont installées sur une paroi extérieure de la chambre à vide de manière étanche ;
au moins deux couches de grilles métalliques (5) sont disposées à l'endroit où les cavités de décharge se raccordent aux parois intérieures de la chambre à vide ; les grilles métalliques sont isolées des parois intérieures de la chambre à vide ; les grilles métalliques sont connectées à une source d'énergie pulsée (6) ; une source de décharge (7) est disposée dans la cavité de décharge (4) et est connectée à une source d'alimentation (8) ; la cavité de décharge est connectée à un tuyau de gaz porteur (9) ; l'autre extrémité du tuyau de gaz porteur est connectée à une source de gaz porteur ; un tuyau de vapeur de monomère (10) est connecté à la chambre à vide, et une extrémité de sortie du tuyau de vapeur de monomère (10) est située en face de la cavité de décharge (4), l'autre extrémité du tuyau de vapeur de monomère étant connectée à une source de vapeur de monomère ;
un tube collecteur de gaz de queue (11) est prévu verticalement le long de l'axe central de la chambre à vide ; une extrémité du tube collecteur de gaz de queue s'étend depuis la chambre à vide et est connectée à une pompe à vide, et les trous sont prévus sur la paroi du tube collecteur de gaz de queue ;
une crémaillère de rotation (12) est disposée dans la chambre à vide ; l'arbre de rotation de la crémaillère de rotation est coaxial à l'axe central de la chambre à vide ; et le substrat à traiter est placé sur le support rotatif.

2. Dispositif de revêtement par polymérisation au plasma selon la revendication 1, dans lequel un couvercle supérieur et un couvercle inférieur de la chambre à vide (1) sont dans une structure plate ou arquée correspondant à la section transversale de la paroi interne du corps de chambre de la partie latérale de la chambre à vide.

3. Dispositif de revêtement par polymérisation au plasma selon la revendication 1, dans lequel les électrodes poreuses (2) sont de forme cylindrique ou au moins divisées en deux sections de forme cylindrique et sont coaxiales avec la chambre à vide, la distance par rapport à la paroi intérieure de la chambre à vide varie de 1 à 6 cm, les électrodes poreuses (2) sont recouvertes de trous traversants, la taille d'un trou traversant varie de 2 à 30 mm, l'espace entre les trous traversants est compris entre 2 à 30 mm, et la puissance de la source d'énergie haute fréquence (3) connectée aux électrodes poreuses est comprise entre 15 à 1000 W.

4. Dispositif de revêtement par polymérisation au plasma selon la revendication 1, dans lequel la cavité de décharge (4) a une forme cylindrique et est faite d'un matériau en aluminium, en acier au carbone ou en acier inoxydable, le diamètre de la cavité de décharge (4) est compris entre 5 à 20 cm, la profondeur de la cavité de décharge (4) est de 3 à 15 cm, la distance entre les axes de deux cavités de décharge voisines (4) est comprise entre 7 à 40 cm, et la distance entre l'extrémité de sortie du tuyau de vapeur de monomère (10) et la cavité de décharge (4) est comprise entre 1 à 10 cm.

5. Dispositif de revêtement par polymérisation au plasma selon la revendication 1, dans lequel le nombre de couches de la grille métallique (5) est compris entre 2 à 6, la grille métallique (5) est en acier inoxydable ou en nickel, la taille des ouvertures de la grille métallique (5) est comprise entre 100 à 1000 mailles, et la transmissivité de la grille métallique (5) est comprise entre 25% à 40%.

6. Dispositif de revêtement par polymérisation au plasma selon la revendication 1, dans lequel la source de puissance d'impulsion (6) émet une impulsion positive avec les paramètres suivants : le pic d'impulsion allant de 20 à 140 V, la largeur d'impulsion allant de 2 µs à 1 ms et la fréquence de répétition allant de 20 Hz à 10 kHz.

7. Dispositif de revêtement par polymérisation au plasma selon la revendication 1, dans lequel la source de décharge (7) est un filament de lampe, une électrode, une bobine d'induction ou une antenne à micro-ondes, et a une puissance de décharge comprise entre 2 à 500 W.

8. Dispositif de revêtement par polymérisation au plasma selon la revendication 1, dans lequel un diamètre intérieur du tube collecteur de gaz de queue (11) est compris entre 25 à 100 mm, les trous du tube collecteur de gaz de queue sont répartis uniformément sur la paroi du tube collecteur de gaz de queue, la taille des trous est comprise entre 2 à 30 mm, et l'espace entre les trous du tube collecteur de gaz de queue varie de 2 à 100 mm.

9. Dispositif de revêtement par polymérisation au plasma selon la revendication 1, dans lequel l'arbre de rotation de la crémaillère de rotation est coaxial à l'axe central de la chambre à vide, la crémaillère de rotation est adaptée pour tourner autour de son arbre de rotation, 2 à 8 couches de plates-formes de substrat sont fixées symétriquement à la crémaillère de rotation, et les plates-formes de substrat sont configurées pour placer le substrat à traiter.

10. Dispositif de revêtement par polymérisation au plasma selon la revendication 1, dans lequel la crémaillère de rotation est adaptée pour tourner autour de son arbre de rotation, 2 à 8 arbres de rotation planétaires (13) sont prévus symétriquement sur la crémaillère de rotation, les arbres de rotation planétaires sont perpendiculaires à la crémaillère de rotation (12) et sont capables de tourner, dans lequel les arbres de rotation planétaires sont pourvus de 2 à 8 couches de plates-formes de substrat de rotation (14), et dans lequel les plates-formes de substrat sont configurées pour placer le substrat à traiter (15).
